(19) Europäisches Patentamt
European Patent Office
Office européen des brevets

(11) **EP 4 618 140 A1**

(12) **EUROPEAN PATENT APPLICATION**
published in accordance with Art. 153(4) EPC

(43) Date of publication:
**17.09.2025 Bulletin 2025/38**

(21) Application number: **23896469.6**

(22) Date of filing: **07.11.2023**

(51) International Patent Classification (IPC):
*H01L 21/68* (2006.01)

(52) Cooperative Patent Classification (CPC):
**H01L 21/67; H01L 21/68; H01L 21/687**

(86) International application number:
**PCT/CN2023/130222**

(87) International publication number:
**WO 2024/114317 (06.06.2024 Gazette 2024/23)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **29.11.2022 CN 202211516242**

(71) Applicant: **Huaying Research Co., Ltd
Wuxi, Jiangsu 214000 (CN)**

(72) Inventors:
• **WEN, Ziying
Wuxi, Jiangsu 214000 (CN)**
• **ZHANG, Jihong
Wuxi, Jiangsu 214000 (CN)**

(74) Representative: **Sun, Yiming
HUASUN Patent- und Rechtsanwälte
Friedrichstraße 33
80801 München (DE)**

(54) **WAFER POSITIONING SYSTEM AND METHOD**

(57)     A semiconductor processing apparatus and a method are provided in the present invention. The method comprises: placing, by a robot, a wafer on a first supporting area of a lower chamber of a semiconductor processing device according to set or updated current position configuration parameters; etching an edge area of the wafer using the semiconductor processing device; performing image acquisition and recognition to the etched wafer placed based on the current position configuration parameters to obtain etched edge information of the wafer; calculating position deviation parameters of the current position configuration parameters using a positioning calibration module with the obtained etched edge information of the wafer; and updating, by a control unit, the current position configuration parameters based on the position deviation parameters to obtain the updated current position configuration parameters, and controlling the robot to place the obtained wafer on the first supporting area of the lower chamber at a position corresponding to the updated current position configuration parameters. In this way, the wafer can be positioned more accurately by calibrating the robot.

900

a robot places a wafer on the first supporting area of a lower chamber in a semiconductor processing device according to set or updated current position configuration parameters — 902

the semiconductor processing device etches the edge area of the wafer — 904

acquire and recognize the image of the etched wafer placed based on the current position configuration parameters to obtain etched edge information — 906

the positioning calibration module calculates position deviation parameters of the current position configuration parameters by using the obtained etched edge information of the wafer — 908

a control unit updates the current position configuration parameters based on the position deviation parameters to obtain the updated current position configuration parameters, and controls the robot to place the fetched wafer on the first supporting area of the lower chamber at a position corresponding to the updated current position configuration parameters — 910

FIG.14

EP 4 618 140 A1

## Description

## Field of the Invention

The present disclosure relates to the field of wafer positioning, and particularly to a wafer positioning system and a wafer positioning method.

## Background technology

Semiconductor wafers are subjected to a number of processing operations to meet the high standards in the semiconductor-related industries. In advanced applications of semiconductor wafers, it is desirable to have edges of semiconductor wafers that are uniform, smooth, damage-free, and polished, which brings challenges to a semiconductor wafer process resulting in its edge surface evenly and precisely etched.

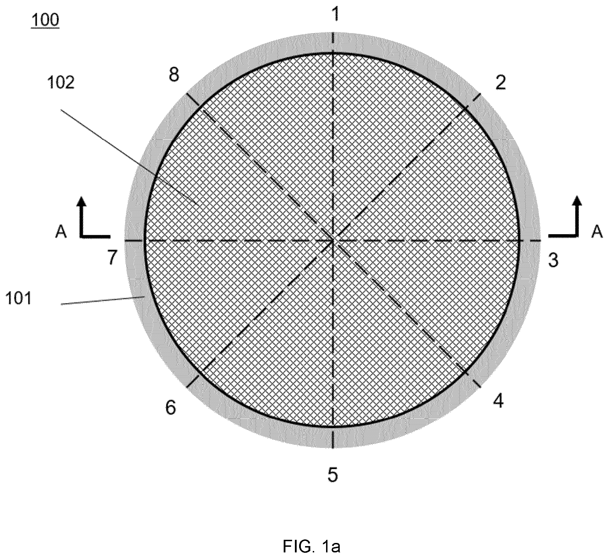

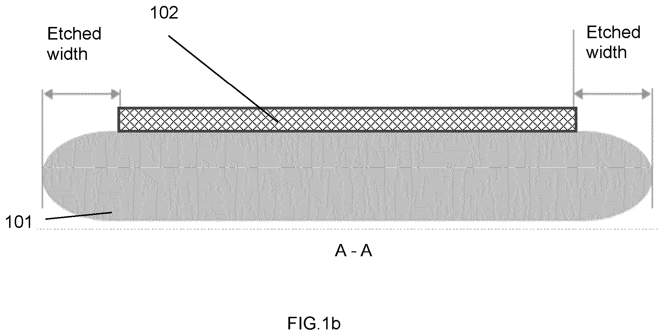

FIG.1a illustrates a top view of a schematic diagram of a semiconductor wafer 100. Semiconductor wafer 100 comprises a substrate layer 101 and a thin layer 102 deposited on substrate layer 101. FIG.1b illustrates a cross-section view of semiconductor wafer 100 along a direction of A-A. Measurement points 1-8 are positions measuring related data of the semiconductor wafer in the processing operations. The etched width refers to the difference between the radius of the substrate layer 101 and the thin layer 102, as illustrated in FIG. 1b. The etched width shall be substantially the same at each of the measurement points 1-8. The smaller the difference between the maximum and minimum etched widths, the higher the uniformity will be. For example, when the edged width is designed for 0.7mm, the difference between a maximum etched width and a minimum etched width shall not be more than 0.1mm, otherwise resulting in an un-even and/or a non-uniform etched width. The difference between the maximum etched width and the minimum etched width, if exceeding 0.1mm, will directly affect the quality of subsequent processing operations and eventually cause poor performance of integrated circuit chips, affecting chip manufacturing yield. The semiconductor wafer 100 shown in FIG. 1a is schematic. In reality, most semiconductor wafers are not perfectly circular. For instance, a 6-inch wafer has a wafer flat while an 8-inch wafer has a notch.

The semiconductor wafer wet processing process has the advantages of a simple principle, flexible process and low cost. There are several conventional methods of etching the semiconductor wafer surface edge. For example, a method of polishing the edge area of the semiconductor wafer has been adopted. It rotates the semiconductor wafer and uses physical friction and chemical gas-liquid combination to remove a thin layer from the substrate layer. The polishing method, however, is mainly used in the manufacturing process of semiconductor wafer with less accuracy requirement and is prone to damaging the retained thin layer as well as the substrate layer. The damaged edges may cause edge slip during thermal processing of the wafer and eventually cause the wafer to be discarded. A method of sucking the semiconductor wafer with a vacuum tip is also commonly adopted. It uses a vacuum tip to suck on the semiconductor wafer where the thin layer is designed to be retained, exposing the rest part of the thin layer outside the vacuum tip, and then immerses the vacuum tip and the semiconductor wafer entirely in a chemical etching solution to etch away the exposed thin layer. However, the vacuum tip method, however, causes the unsmooth removal of the thin layer and uneven etched widths. Similarly, a method of depositing a pre-trimmed thin layer onto the substrate layer of the wafer will cause the uneven etched widths, as the center of the pre-trimmed thin layer may not be aligned with the center of the substrate layer of the wafer. Another commonly used method is the filming method, which uses pure anticorrosive PTFE, PE and other plastic films to protect the parts of the film that need to be retained, and then exposes the whole to a chemically corrosive gas environment or soaks in a chemical corrosive solution to corrode the exposed parts. The filming method is often because the center of the pre-cut film may not be aligned with the center of the wafer substrate, resulting in uneven etching width; and there are many process steps, which need to use a variety of equipment to complete, including filming, wet etching, cleaning and removal of film and other equipment. Similarly, a new method of shower, which works by using a special nozzle to spray the fluid used for etching the edge of the rotating wafer to etching areas, for accurate, uniform, smooth and no damage etching. Although the shower method has a higher etching effect, but its design of equipment and parts of the processing precision requirements are very high, the equipment and process cost is too high.

All advanced wafer edge etching technologies and equipment must address the issue of precise wafer positioning to meet the increasingly stringent requirements for edge etching uniformity and tolerance. This is because during edge etching, the accuracy of the semiconductor wafer positioning directly determines the uniformity of the etched width. Therefore, it is necessary to propose a system and method that can continuously fine-tune and improve the wafer positioning.

## SUMMARY OF THE INVENTION

The present disclosure provides a continuously improvable wafer positioning system and method. Through multiple fine-tuning and calibration of position configuration parameters of a robot, the robot can precisely place the wafer at the desired position.

To achieve this objective, in one aspect, the present disclosure provides a wafer positioning system. The wafer positioning system comprises: a semiconductor processing device comprising a lower chamber with a first supporting area and an upper chamber with a second supporting area, wherein when the upper chamber engages with the lower chamber with a wafer placed between the first supporting area and the second supporting area, a first channel is formed at an edge area of the first supporting area and/or the second supporting area, and the first channel is configured to provide a first space for flow of one or more chemical fluids for etching an edge area of the wafer; a wafer transfer device comprising a robot and a control unit, wherein the control unit is configured to set or update current position configuration parameters, and the robot is configured to place the fetched wafer on the first supporting area of the lower chamber at a position corresponding to the set or updated current position configuration parameters; an image edge detection device is configured to acquire and recognize images of the etched wafer placed based on the current position configuration parameters to obtain etched edge information of the wafer; a positioning calibration module is configured to calculate position deviation parameters of the current position configuration parameters using the etched edge information obtained through image recognition; wherein the control unit is further configured to update the current position configuration parameters based on the position deviation parameters to obtain the updated current position configuration parameters, and control the robot to place the fetched wafer on the first supporting area of the lower chamber at a position corresponding to the updated current position configuration parameters.

In another aspect, the present disclosure provides a wafer positioning method. The method comprises: placing, by a robot, a wafer on a first supporting area of a lower chamber of a semiconductor processing device according to set or updated current position configuration parameters; etching an edge area of the wafer using the semiconductor processing device; performing image acquisition and recognition to the etched wafer placed based on the current position configuration parameters to obtain etched edge information of the wafer; calculating position deviation parameters of the current position configuration parameters using a positioning calibration module with the obtained etched edge information of the wafer; and updating, by a control unit, the current position configuration parameters based on the position deviation parameters to obtain the updated current position configuration parameters, and controlling the robot to place the obtained wafer on the first supporting area of the lower chamber at a position corresponding to the updated current position configuration parameters.

Compared to the existing technologies, the present disclosure achieves precise wafer positioning by analyzing the etched edge information to iteratively calibrate the positional parameters of the robot. By calculating the position deviation parameters based on the etched edge information and updating the current position configuration parameters accordingly, the system dynamically fine-tunes the placement accuracy of the robot. This ensures that the wafer is placed more precisely on the first supporting area of the lower chamber, resulting in more uniform edge etching.

It will therefore be appreciated that this summary is provided merely for purposes of summarizing some exemplary embodiments so as to provide a basic understanding of some aspects of the disclosure. Accordingly, it will be appreciated that the above described exemplary embodiments are merely examples and should not be construed to narrow the scope or spirit of the disclosure in any way. Other example embodiments, aspects, and advantages will become apparent from the following detailed description taken in conjunction with the accompanying figures which illustrate, by way of example, the principles of some described exemplary embodiments.

## BRIEF DESCRIPTION OF THE DRAWINGS

The present disclosure may be better understood by referring to the drawings as well as the detailed description below. In particular, same numerals are used to refer to same structural parts throughout the drawings, and wherein:

FIG. 1a illustrates a top view of a schematic diagram of a semiconductor wafer;

FIG. 1b illustrates a cross-section view of the semiconductor wafer along a direction A-A of FIG. 1a;

FIG. 2a illustrates a cross-section view of an exemplary device, according to exemplary embodiments of the present disclosure;

FIG. 2b illustrates a detailed view of a circle A shown in FIG. 2a;

FIG. 2c illustrates a detailed view of a circle B shown in FIG. 2b;

FIG. 2d illustrates a detailed view of a circle C shown in FIG. 2c;

FIG. 2e illustrates a bottom view of an upper chamber of exemplary device;

FIG. 2f illustrates a top view of a lower chamber of exemplary device;

FIG. 3 illustrates an exemplary system comprising a semiconductor processing device and a material storage device;

FIG. 4 illustrates an exemplary method using an device to process an edge area of a semiconductor wafer, according to exemplary embodiments of the present disclosure;

FIG. 5 illustrates a block diagram of the wafer positioning system in one embodiment;

FIG. 6 illustrates a 3D schematic of the image edge detection device in one embodiment;

FIG. 7 illustrates a side view of the image edge detection device in FIG. 6;

FIG. 8 illustrates a schematic of the edge recognition results from the acquired images;

FIG. 9 illustrates a comparison between an acquired image of an etched wafer and its HLS image;

FIG.10 illustrates a schematic of the multiple lines identified through the edge recognition on an HLS image;

FIG.11 illustrates a flowchart of an edge etched detection method for a wafer according to an embodiment of the present disclosure;

FIG.12 illustrates a top view of a 6-inch wafer with the edge etched;

FIG.13 illustrates a top view of an 8-inch or larger wafer with the edge etched; and

FIG.14 illustrates a flowchart of the wafer positioning method in one embodiment.

**DETAILED DESCRIPTION OF THE PREFERRED**

Some embodiments of the present disclosure will now be described more fully hereinafter with reference to the accompanying figures, in which some, but not all embodiments of the disclosure are shown. Indeed, various embodiments of the disclosure may be embodied in many different forms and should not be construed as limited to the embodiments set forth herein; rather, these exemplary embodiments are provided so that this disclosure will be thorough and complete, and will fully convey the scope of the disclosure to those skilled in the art. For example, unless otherwise indicated, reference to something as being a first, second or the like should not be construed to imply a particular order. Also, something may be described as being above something else (unless otherwise indicated) may instead be below, and vice versa; and similarly, something described as being to the left of something else may instead be to the right, and vice versa. Like reference numerals refer to like elements throughout.

FIGs. 1a through 1b illustrate a schematic diagram of a semiconductor wafer 100. FIG. 1a illustrates a top view of the schematic diagram of a semiconductor wafer 100. FIG. 1b illustrates a cross-section view of semiconductor wafer 100 along the direction A-A of FIG. 1a. As shown in FIGs. 1a-1b, semiconductor wafer 100 includes a substrate layer 101 and a thin layer 102 deposited on the first side surface of substrate layer 101, and substrate layer 101 can be partially covered by thin layer 102. In another embodiment, substrate layer 101 can be fully covered by thin layer 102. In another embodiment, both sides of surface of substrate layer 101 can be respectively covered by a thin layer 102.

In some embodiments, in processing operations of the semiconductor wafer, thin layer 102 shall be removed from substrate layer 101. For example, as shown in FIGs. 1a-1b, a radius of substrate layer 101 is smaller than a radius of thin layer 102, and an etched width refers to a difference between the two radii. Measurement points 1-8 are positions that measure related data of the semiconductor wafer, as illustrated in FIG. 1a. The etched width shall be substantially the same at each of the measurement points 1-8. The smaller the difference between the maximum and minimum etched widths, the higher the uniformity will be. For example, when the edged width is designed for 0.7mm, the difference between the maximum etched width and the minimum etched width shall not be more than 0.1mm. In some embodiments, thin layers covering both sides of a surface of substrate layer 101 shall be partially or completely removed. The etched width for each side of the surface of substrate layer 101 can be the same or different.

Part I

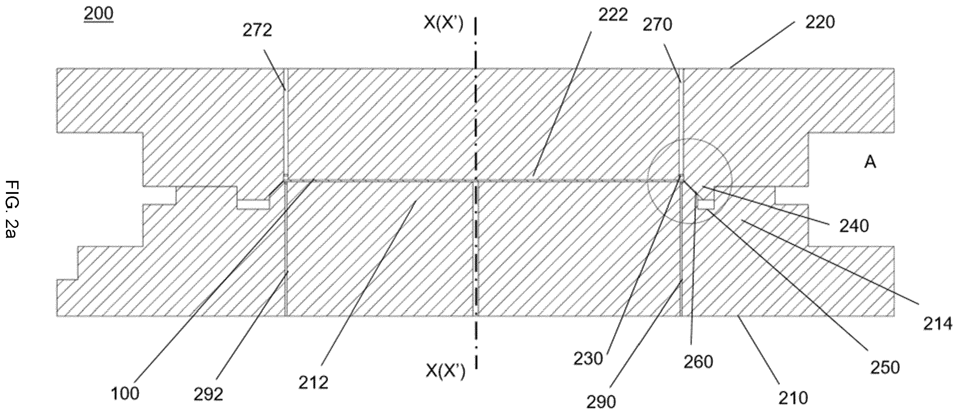

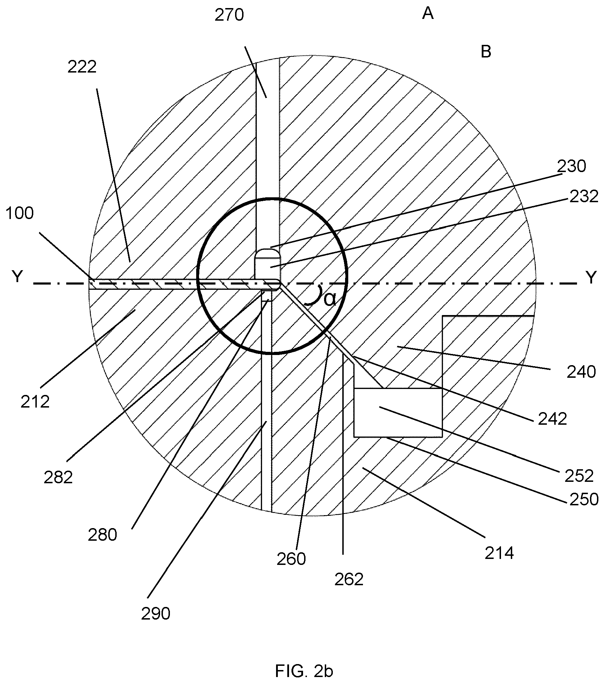

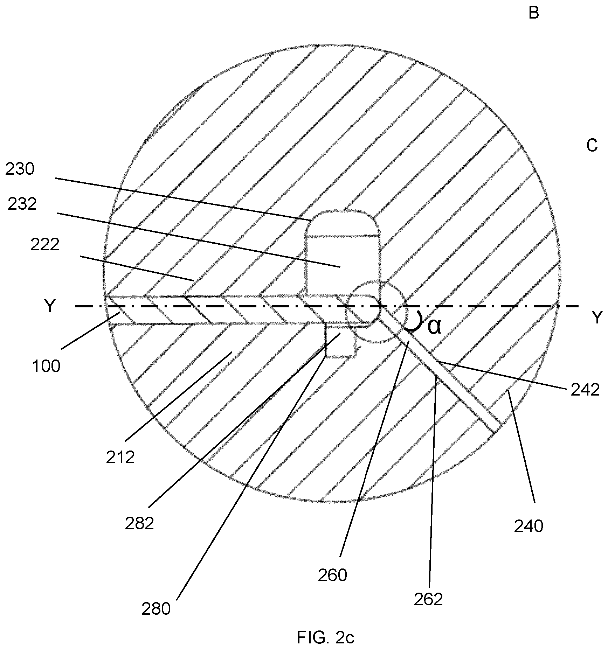

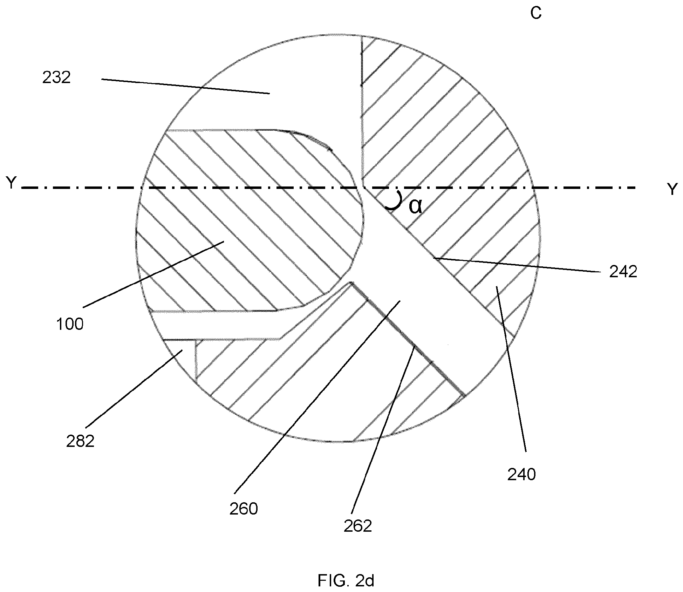

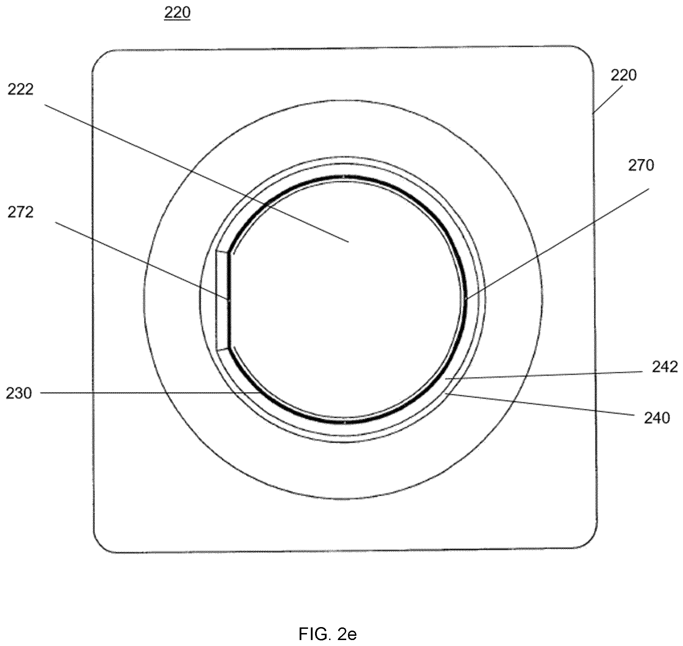

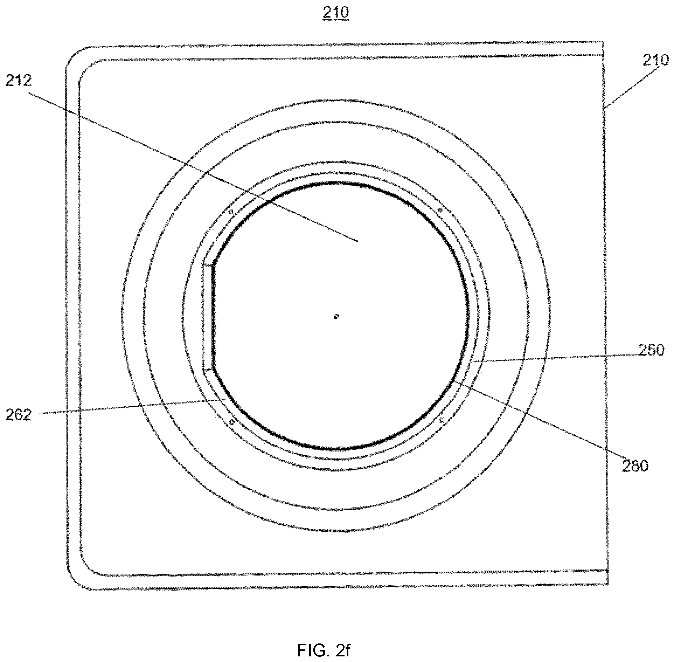

FIGs. 2a through 2f illustrate an exemplary device 200, according to exemplary embodiments of the present disclosure. FIG. 2a illustrates a cross-section view of exemplary device 200. FIG. 2b illustrates a detailed view of a circle A shown in FIG. 2a. FIG. 2c illustrates a simplified detailed view of a circle B shown in FIG. 2b (omitting through holes). FIG. 2d illustrates a detailed view of a circle C shown in FIG. 2c. FIG. 2e illustrates a bottom view of an upper chamber 220 of exemplary device 200. FIG. 2f illustrates a top view of a lower chamber 210 of exemplary device 200.

In one exemplary embodiment, device 200 comprises a lower chamber 210 having a first supporting area 212. First supporting area 212 may be configured to support a wafer 100 as described above with reference to FIG. 1and FIGs. 2a through 2f. For example, as shown in FIG. 2a, first supporting area 212 may have an upper surface facing wafer 100. Wafer 100 may be placed on the upper surface of first supporting area 212. In some embodiments, device 200 may comprise an upper chamber 220 having a second supporting area 222. For example, as shown FIG. 2a, second supporting area 222 may have a lower surface facing wafer 100. Upper chamber 220 may be engaged with lower chamber 210 to place wafer 100 between first supporting area 212 and second supporting area 222. For example, upper chamber 220 may move between two positions relative to lower chamber 210. In the first position, wafer 100 can be loaded to and/or unloaded from first supporting area 212. In the second position, upper chamber 220 and lower chamber 210 are engaged with each other so that wafer 100 may be fixed by the upper surface of first supporting area 212 and the lower surface of second supporting area 222 and may be accommodated for processing, as shown in FIG. 2a. In one embodiment, the upper chamber 220 can be driven to move between two relative positions, while the lower chamber 210 remains stationary. Of course, the lower chamber 210 can also be driven to move between two relative positions while the upper chamber 220 remains stationary. Moreover, both the lower chamber 210 and the upper chamber 220 can be driven simultaneously.

In some embodiments or any combination of preceding exemplary embodiments of device 200, as shown in FIGs. 2a through 2c, device 200 may comprise a first channel 230 formed at a peripheral area of first supporting area 212 or second supporting area 222. First channel 230 may be configured to provide a first space 232 for the flow of one or more chemical fluids for etching an edge area of wafer 100. For example, as shown in FIGs. 2a through 2c, first channel 230 may be formed at the peripheral area of second supporting area 222 in upper chamber 220. First channel 230 may be further formed on a lower surface of upper chamber 220, and an opening of first channel 230 may face wafer 100. In one embodiment, first channel 230 may be configured to provide a first space 232, in which one or more chemical fluids may flow to etch the edge area of wafer 100. For example, as shown in FIGs. 2a through 2c, first space 232 may be formed by an internal surface of first channel 230 and wafer 100. In one embodiment, first channel 230 may be annular and around the edge area of wafer 100. The entire edge area of wafer 100 may be accommodated into first space 232. In another embodiment, first channel 230 may be arranged as an arc with a radian less than 360 degrees, and an edge area of wafer 100 may be selectively accommodated into first space 232. Then, the one or more chemical fluids may etch part of the edge area of the wafer in accordance with the arc of first channel 230.

In some embodiments or any combination of preceding exemplary embodiments of device 200, as shown in FIGs. 2a through 2c, upper chamber 220 may comprise a protrusion part 240 configured to press against an edge of wafer 100. For example, the protrusion part may directly contact an edge of wafer 100, and further press against the edge of wafer 100. In some embodiments, as shown in FIG. 2a, a center axis X-X of wafer 100 may be perpendicular to an upper surface of wafer 100. A center axis X'-X' of second supporting area 222 may be perpendicular to a lower surface of second supporting area 222. A protrusion part 240 may be configured to align the center axis X-X of wafer 100 with the center axis X'-X' of second supporting area 222. For example, when upper chamber 220 is located in a first position, wafer 100 is loaded onto first supporting area 212. The center axis X-X of wafer 100 may not be aligned to the center axis X'-X' of a second supporting area 222. During the course that upper chamber 220 moves from a first position to a second position, protrusion part 240 may contact an edge of wafer 100, and then may press against an edge of wafer 100, pushing wafer 100 to move on an upper surface of first supporting area 212. When upper chamber 220 is located in the second position, the wafer may be fixed on the upper surface of first supporting area 212 and the center axis X-X of wafer 100 may be parallel to the center axis X'-X' of second supporting area 222. In another embodiment, the center axis X-X of wafer 100 may overlap the center axis X'-X' of second supporting area 222.

In some embodiments or any combination of preceding exemplary embodiments of device 200, protrusion part 240 may be adjacent to second supporting area 222 and extend toward lower chamber 210. For example, as shown in FIGs. 2a and 2b, protrusion part 240 may be connected to second supporting area 222. Protrusion part 240 may extend toward lower chamber 210 where upper chamber 220 is located in a second position. In one embodiment, protrusion part 240 may be formed next to first channel 230, as shown in FIGs. 2a and 2b. In some embodiments, as shown in FIG. 2a, the center axis X-X of wafer 100 may be perpendicular to an upper surface of wafer 100 and the center axis X'-X' of second supporting area 222 may be perpendicular to a lower surface of upper chamber 220. The upper surface of wafer 100 may be parallel to the lower surface of the second supporting area. In one embodiment, when the upper chamber is located in the second position, the upper surface of wafer 100 may overlap the lower surface of second supporting area 222 and the center axis X-X of wafer 100 may overlap the center axis X'-X' of second supporting area 222.

In some embodiments or any combination of preceding exemplary embodiments of the device 200, protrusion part 240 may include a closed loop arranged around wafer 100. For example, as shown in FIG. 2a, protrusion part 240 includes a closed loop. The closed loop may be annular and around the entire edge area of wafer 100. Protrusion part 240 therefore may uniformly press against the edge area of wafer 100 for overlapping the center axis X-X of wafer 100 with the center axis X'-X' of second supporting area 222. In some embodiments, the closed loop may include an arc with a radian less than 360 degrees, and the edge area of wafer 100 may be selectively resisted by protrusion part 240 for aligning and/or overlapping the center axis X-X of wafer 100 with the center axis X'-X' of second supporting area 222. In some embodiment, protrusion part 240 may include an open loop.

In some embodiments or any combination of preceding exemplary embodiments of device 200, protrusion part 240 includes an inner corner facing towards the center axis X'-X' of second supporting area 222. For example, as shown in FIG. 2c, protrusion part 240 may comprise an inner surface 242 inclining at an angle α to a first reference direction Y-Y. The first reference direction Y-Y may be parallel to a lower surface of second supporting area 222. The angle $\alpha$ may be within a range of 20°-90°. The inner corner may be formed by inner surface 242 and an inner surface of first channel 230 and may face towards the center axis X'-X' of second supporting area 222, as shown in FIGs. 2b and 2c. In one embodiment, the inner corner may be configured to press against an edge area of wafer 100. For examples, as shown in FIG. 2b, during the course that upper chamber 220 moves from a first position to a second position, an inner corner of protrusion part 240 may contact an edge area of wafer 100, and then may press against an edge of wafer 100, pushing wafer 100 to move. When upper chamber 220 is located in the second position, the wafer may be fixed and the center axis X-X of wafer 100 may be parallel to the center axis X'-X' of second supporting area 222. In another embodiment, the center axis X-X of wafer 100 may overlap the center axis X'-X' of second supporting area 222.

In some embodiments or any combination of preceding exemplary embodiments of device 200, a first groove 250 may be formed in a peripheral area 214 of lower chamber 210 and configured to provide a first groove space 252 for the flow of one or more chemical fluids. For example, as shown in FIGs. 2a, 2b and 2f, first groove 250 may be formed in peripheral area 214 of lower chamber 210, and positioned close to first supporting area 212 of lower chamber 210. First groove 250 may provide a first groove space 252 and the one or more materials can flow from first space 232 of first channel 230 to first groove space 252.

In some embodiments or any combination of preceding exemplary embodiments of device 200, a passage 260 may be formed between upper chamber 220 and lower chamber 210. For example, as shown in FIGs. 2b and 2f, lower chamber 210 may comprise a first upper surface 262 between first supporting area 212 and first groove 250. Passage 260 may be formed between first upper surface 262 of lower chamber 210 and inner surface 242 of protrusion part 240. Passage 260 may connect first space 232 with first groove space 252 for allowing the one or more chemical fluids to flow from first space 232 to first groove space 252 through passage 260. In one embodiment, passage 260 may be blocked by protrusion part 240 from the flow of the one or more chemical fluids from first space 232 to first groove space 252. In another embodiment, passage 260 may be blocked by first supporting area 210 from the flow of the one or more chemical fluids from first space 232 to first groove space 252.

In some embodiments or any combination of preceding exemplary embodiments of device 200, a first channel 230 may be formed at a peripheral area of second supporting area 222, as shown in FIGs, 2a through 2c. Upper chamber 220 may further comprise a first through hole 270 configured to allow the one or more chemical fluids to flow between a first space 232 and an outside of device 200. For example, first through hole 270 may pass through upper chamber 220 from an outside of device 200 to communicate with first space 232. In one embodiment, the one or more chemical fluids may flow between first space 232 and an outside of device 200 through first through hole 270. In another embodiment, upper chamber 220 may further comprise two or more first through holes (e.g., a secondary first through hole 272, as shown in FIGs. 2a and 2e) which may be substantially the same as the first through hole 270. In this embodiment, at least one first through hole (e.g., first through hole 270) may be configured to serve as an inlet and the rest first through hole(s) (e.g., the secondary first through hole 272) may be configured to serve as an outlet. First space 232 may connect to an outside of device 200 through first through hole 270 and secondary first through hole 272. In this embodiment, the one or more chemical fluids may flow into first space 232 of first channel 230 from the outside of device 200 through first through hole 270, and flow out of first space 232 to the outside of device 200 through secondary first through hole 272.

In some embodiments or any combination of preceding exemplary embodiments of device 200, a second channel 280 may be formed at a peripheral area of first supporting area 212 and configured to provide a second space 282 for the flow of one or more chemical fluids for etching an edge area of wafer 100. For example, as shown in FIGs. 2a through 2c, a second channel 280 may be formed at a peripheral area of first supporting area 212 in lower chamber 210. Second channel 280 may be further formed on an upper surface of lower chamber 210, and an opening of second channel 280 may face toward wafer 100, as shown in FIGs. 2a and 2f. In one embodiment, second channel 280 may be configured to provide a second space 282, in which the one or more chemical fluids may flow to etch an edge area of wafer 100. For example, as shown in FIGs. 2a through 2c, a second space may be formed by an internal surface of second channel 280 and wafer 100. In one embodiment, second channel 280 may be annular and around an edge area of wafer 100. The entire edge area of wafer 100 may be accommodated into second space 282. In another embodiment, second channel 280 may be arranged as an arc with a radian less than 360 degrees, and the edge area of wafer 100 may be selectively accommodated into second space 282. Then, the one or more chemical fluids may etch a part of the edge area of the wafer in accordance with the arc of the second channel 280. In some embodiments, second channel 280 may be arranged in a shape identical to first channel 230. In some embodiments, second channel 280 may be arranged close to first upper surface 262 between first supporting area 212 and first groove 250. A passage 260 may be formed between first upper surface 262 of lower chamber 210. Passage 260 may connect second space 282 with first groove space 252 for allowing the one or more chemical fluids to flow from second space 282 to first groove space 252 through passage 260. In one embodiment, passage 260 may be blocked by protrusion part 240 from the flow of the one or more chemical fluids from second space 282 to first groove space 252. In another embodiment, passage 260 may be blocked by first supporting area 210 from the flow of the one or more chemical fluids from second space 282 to first groove space 252.

In some embodiments or any combination of preceding exemplary embodiments of device 200, lower chamber 210 may comprise a second through hole 290 configured to allow one or more chemical fluids to flow between a second space 282 and an outside of device 200. For example, as shown in FIGs. 2a and 2b, second through hole 290 may pass through lower chamber 210 from an outside of device 200 to communicate with second space 282 of second channel 280. In one embodiment, the one or more chemical fluids may flow between second space 282 and the outside of device 200 through second through hole 290. In another embodiment, the one or more chemical fluids may flow from the outside of device 200 to second space 282 of second channel 280 through second through hole 290, and then flow from second space 282 of second channel 280 to first groove space 252 of first groove 250 through passage 260. In some embodiments, lower chamber 210 may further comprise one or more second through holes (e.g., a secondary second through hole 292, as shown in FIG. 2a) which may be substantially the same as second through hole 290. In this embodiment, at least one second through hole (e.g., a second through hole 290) may be configured to serve as an inlet and the rest second through hole(s) (e.g., secondary second through hole(s) 292) may be configured to serve as an outlet. Second space 282 may connect to an outside of device 200 through second through hole 290 and secondary second through hole 292. In one embodiment, the one or more materials may flow into second space 282 of second channel 280 from the outside of device 200 through second through hole 290, and flow out of second space 282 to the outside of device 200 through secondary second through hole 292. In another embodiment, the one or more chemical fluids may flow into second space 282 of second channel 280 from the outside of device 200 through second through hole 290 and secondary second through hole 292, and then flow from second space 282 of second channel 280 to first groove space 252 of first groove 250 through passage 260.

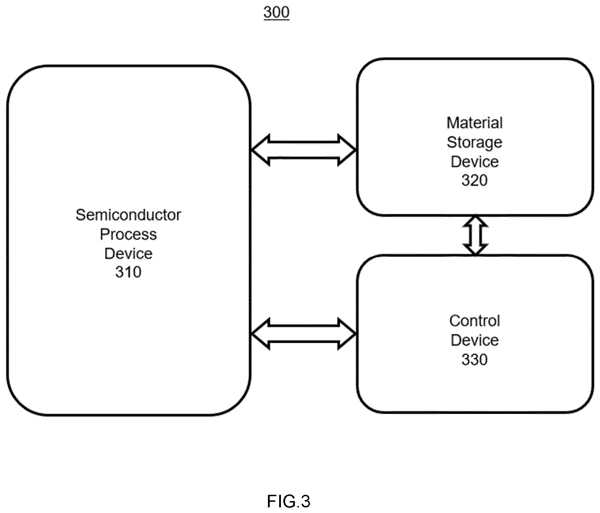

FIG. 3 illustrates an exemplary system 300 comprising a semiconductor processing device 310 and a material storage device 320, according to exemplary embodiments of the present disclosure. Processing device 310 may be referred to the device 200 as described above with reference to FIGs. 2a-2f. Processing device 310 may comprise a lower chamber having a first supporting area configured to support a wafer; an upper chamber having a second supporting area, and the upper chamber being engaged with the lower chamber to place the wafer between the first supporting area and the second supporting area; and a first channel formed at a peripheral area of the first supporting area or the second supporting area, the first channel being configured to provide a first space for the flow of one or more chemical fluids for etching an edge area of the wafer. In some embodiments, the upper chamber comprises a protrusion part being configured to press against an edge of the wafer and to align a center axis of the wafer with a center axis of the second supporting area. The material storage device 320 may be connected to processing device 310. The material storage device may be configured to store the one or more chemical fluids and transfer the one or more chemical fluids between the processing device 310 and the material storage device 320. In some embodiments, the one or more chemical fluids may be selected from $H_3PO_4$, HF, HCl, $HNO_3$, $H_2O_2$, or any combination thereof.

In some embodiments or any combination of preceding exemplary embodiments of system 300, the protrusion part may be adjacent to the second supporting area and extend toward the lower chamber. The center axis of the wafer may be perpendicular to an upper surface of the wafer, the center axis of the second supporting area being perpendicular to a lower surface of the upper chamber, and the upper surface of the wafer being parallel to the lower surface of the second supporting area. In some embodiments, the protrusion part may include a closed loop arranged around the wafer, and the protrusion part is configured to uniformly press against an edge area of the wafer for overlapping a center axis of the protrusion part with the center axis of the second supporting area.

In some embodiments or any combination of preceding exemplary embodiments of system 300, the protrusion part may be adjacent to the second supporting area and extend toward the lower chamber. The center axis of the wafer may be perpendicular to an upper surface of the wafer, the center axis of the second supporting area being perpendicular to a lower surface of the upper chamber, and the upper surface of the wafer being parallel to the lower surface of the second supporting area. In some embodiments, the protrusion part may include a plurality of juts being circularly and evenly arranged around the wafer to uniformly press against the edge area of the wafer.

In some embodiments or any combination of preceding exemplary embodiments of system 300, a first groove may be formed at a peripheral area of the lower chamber and configured to provide a first groove space for the flow of one or more chemical fluids. In some embodiments, a passage may be formed between the upper chamber and the lower chamber, connecting the first space with the first groove space for allowing the one or more chemical fluids to flow from the first space to the first groove space through the passage. In some embodiments, a second groove may be formed at a peripheral area of the upper chamber and positioned above the first groove. In some embodiments, an elastic component may be placed between the first groove and the second groove for blocking the one or more chemical fluids from flowing from the first space to the first groove space.

In some embodiments or any combination of preceding exemplary embodiments of system 300, system 300 may comprise a control device 330. Control device 330 may communicate and control processing device 310 and material storage device 320. For example, control device 330 can control a move of the upper chamber between a first position of loading/unloading the wafer and a second position of engaging the upper chamber and the lower chamber to process the wafer, the speed of the flow of the one or more chemical fluids, and the direction of the flow of the one or more chemical fluids. Control device 330 can detect the speed of the flow of the one or more chemical fluids, the direction of the flow of the one or more chemical fluids, the condition of the one or more chemical fluids, and the mal-function of processing device 310. In some embodiments, control device may comprise a PLC, a controller, a sensor, a storage device (e.g., memory, hard drive, SSD, etc.).

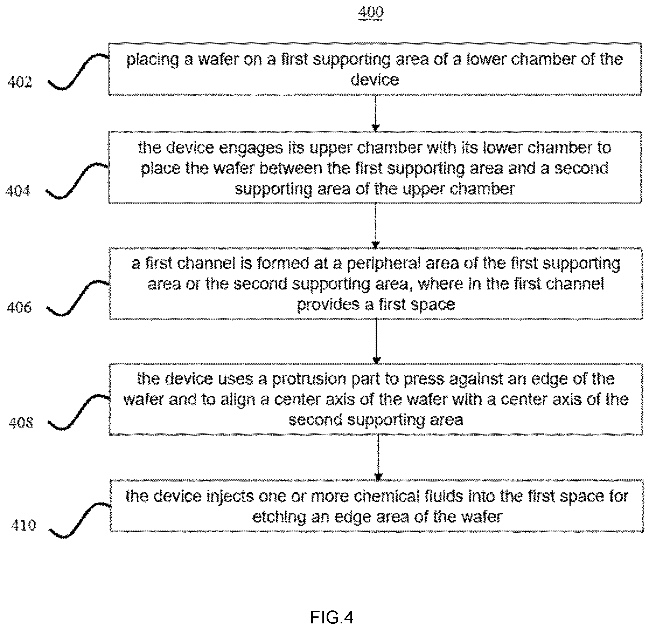

FIG. 4 illustrates an exemplary method 400 using an device to process an edge area of a semiconductor wafer 100, according to exemplary embodiments of the present disclosure. The method may utilize the device which may be referred to the system as described above with reference to FIGs. 2a-2f, and 3.

In an exemplary embodiment, as shown in Fig. 4, at step 402, an device 200 receives and places a wafer on a first supporting area of a lower chamber of the device. At step 404, the device engages its upper chamber with its lower chamber to place the wafer between the first supporting area and a second supporting area of the upper chamber. At step 406, a first channel is formed at a peripheral area of the first supporting area or the second supporting area, where in the first channel provides a first space. At step 408, the device uses a protrusion part to press against an edge of the wafer and to align a center axis of the wafer with a center axis of the second supporting area. At step 410, the device injects one or more chemical fluids into the first space for etching an edge area of the wafer.

In some embodiments or any combination of preceding exemplary embodiments of method 400, at step 402, a wafer may be conveyed by a wafer conveying device to device 200. The wafer may further be placed by the wafer conveying device onto a first supporting area of a lower chamber of device 200. The first supporting area may have an upper surface facing the wafer. The wafer may be placed on the upper surface of the first supporting area. The wafer conveying device may place the wafer onto the first supporting area in a way that part of a lower surface of the wafer is covered by an upper surface of the first supporting area. In some embodiments, the upper chamber of device 200 may be in a first position, where the wafer can be loaded to and/or unloaded from the first supporting area. For example, the wafer can be conveyed from the wafer conveying device to the upper surface of the first supporting area.

In some embodiments or any combination of preceding exemplary embodiments of method 400, at step 404, device 200 may engage an upper chamber with its lower chamber to place a wafer between a first supporting area and a second supporting area of the upper chamber. The upper chamber is in a second position where the lower chamber may be engaged with the upper chamber and the wafer may be fixed between the lower chamber and the upper chamber for allowing a process of an edge area of the wafer. The upper chamber may comprise a second supporting area, which may have a lower surface facing the wafer. The upper chamber may be engaged with the lower chamber to place the wafer between the first supporting area and the second supporting area. For example, the wafer may be fixed between the lower surface of the second supporting area and the upper surface of the first supporting area.

In some embodiments or any combination of preceding exemplary embodiments of method 400, at step 406 , a first channel may be formed at a peripheral area of a first supporting area. The first channel may be further formed on a lower surface of the upper chamber, and an opening of the first channel may face the wafer. In some embodiments, the first channel provides a first space for allowing a process of an edge area of a wafer. For example, one or more chemical fluids may flow in the first channel and etch an edge area of wafer. In some embodiments, the first channel may be arranged as a closed loop. In some embodiments, the first channel may be arranged as a circle. device 200 or the wafer conveying device may place the wafer in a way that an entire or a partial edge area of the wafer is accommodated into the first space for processing. In some embodiments, the first channel may be arranged as an arc with a radian less than 360 degrees. device 200 or the wafer conveying device may place the wafer in a way that a partial edge area of the wafer is accommodated into the first space for processing.

In some embodiments or any combination of preceding exemplary embodiments of method 400, at step 408, a protrusion part is formed on an upper chamber or a lower chamber of device 200. The device may use the protrusion part to press against an edge of a wafer. For example, the protrusion part may contact the edge of the wafer during a course that the upper chamber moves from a first position to a second position. Then the protrusion part may press against the edge of the wafer and push the wafer to move on an upper surface of a first supporting area of the lower chamber. When the upper chamber is engaged with the lower chamber, the wafer may be fixed on the upper surface of the first supporting area, and a center axis X-X of the wafer may be aligned with a center axis X'-X' of a second supporting area. A distance between the center axis X-X of the wafer and the center axis X'-X' of the second supporting area may be within a range of 0mm-0.1mm. In some embodiments, the protrusion part may be adjacent to the second supporting area and extend toward the lower chamber. In one embodiment, the protrusion part may be formed next to the first channel.

In some embodiments, the protrusion part includes an inner corner facing towards the center axis X'-X' of the second supporting area. The inner corner may be formed by an inner surface of the protrusion part and an inner surface of the first channel and may face towards the center axis X'-X' of the second supporting area. In one embodiment, the inner corner may be configured to press against an edge area of the wafer. For example, during the course that the upper chamber moves from a first position to a second position, the inner corner of the protrusion part may contact an edge of the wafer, and then may press against the edge of the wafer, pushing the wafer to move. In some embodiments, the inner surface of the protrusion part may contact an edge of the wafer, and then may press against the edge of the wafer, pushing the wafer to move.

In some embodiments or any combination of preceding exemplary embodiments of method 400, at step 410, device 200 may inject one or more chemical fluids into a first space for etching an edge area of a wafer. The one or more chemical fluids may flow around an edge of the wafer in a first space and etch the edge area of the wafer accommodated into the first space. In some embodiments, the device may comprise a through hole connecting the first space with an outside of the device. The one or more chemical fluids may be injected into the first space through the through hole. In some embodiments, the one or more chemical fluids may flow from the first space into the outside of the device through the through hole. In some embodiments, the device may comprise two through holes, each of which may respectively connect the first space with the outside of the device. The two through holes may be arranged with a distance away to each other. The one or more chemical fluids may be injected into the first space through one through hole and flow from the first space into the outside of the device through the other through hole.

Part II

By adopting the chamber center positioning method shown in FIGs. 2a-2f, the chamber mechanism and the protrusion part are used to align the wafer with the center of the chamber. However, in some cases, the protrusion part 240 may clamp the wafer or prevent the portion of the wafer in contact with the protrusion part 240 from being etched. Therefore, it is necessary to propose a new wafer positioning solution to solve this problem. In this new solution, the protrusion part 240 may not be provided for wafer positioning, or the protrusion part 240 may be provided simultaneously for wafer positioning.

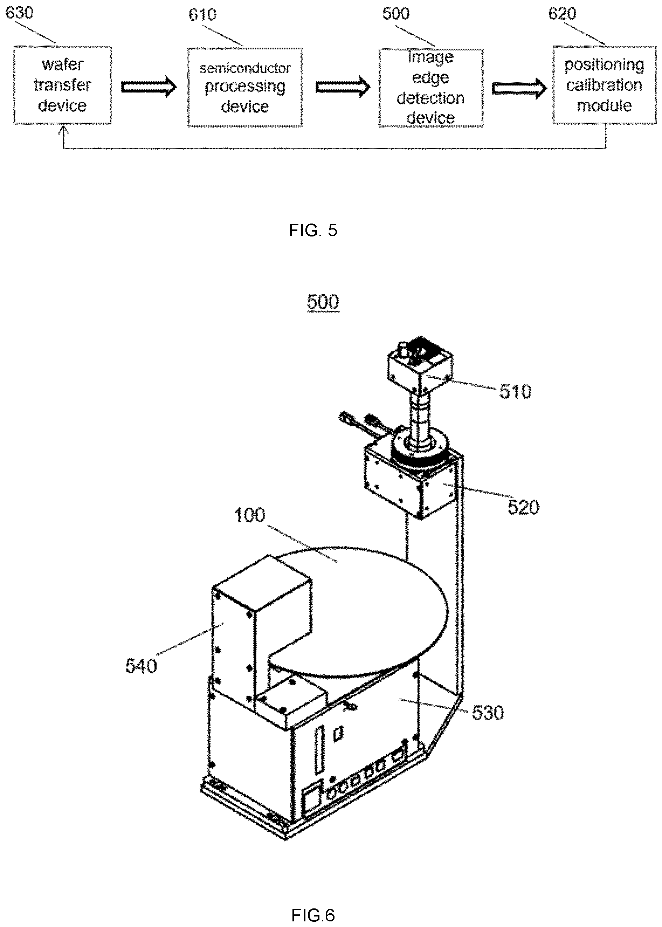

FIG. 5 illustrates a block diagram of the wafer positioning system according to the present disclosure. As FIG.5 has shown, the wafer positioning system comprises a semiconductor processing device 610, an image edge detection device 500, a positioning calibration module 620, and a wafer transfer device 630. The semiconductor processing device 610 may be the semiconductor processing device 200 described in Part I for etching the edge of the wafer 100. The semiconductor processing device 610 may be a modified embodiment of the semiconductor processing device 200, such as removing the protrusion part in semiconductor device 200, which was originally used for positioning wafer 100. in some occasions, the positioning calibration module 620 may be integrated with the image edge detection device 500 or with the wafer transfer device 630. Additionally, the positioning calibration module 620, the image edge detection device 500, and the wafer transfer device 630 may be fully integrated together.

The image edge detection device 500 is configured to perform rapid image detection on the edge etching effect of the etched wafer 100 for immediate evaluation of the edge etching effect. The wafer transfer device may be used to transfer the etched wafer 100 from the semiconductor processing device 610 to the image edge detection device 500.

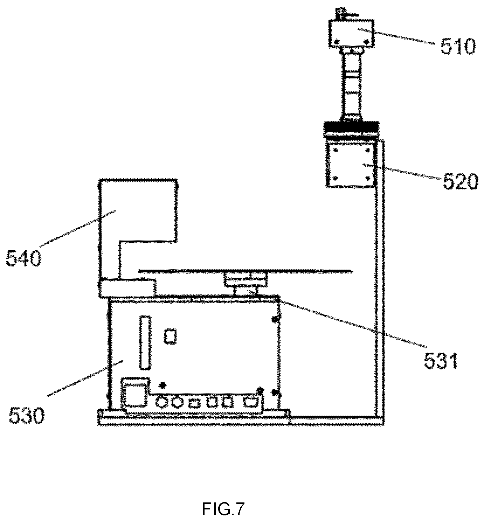

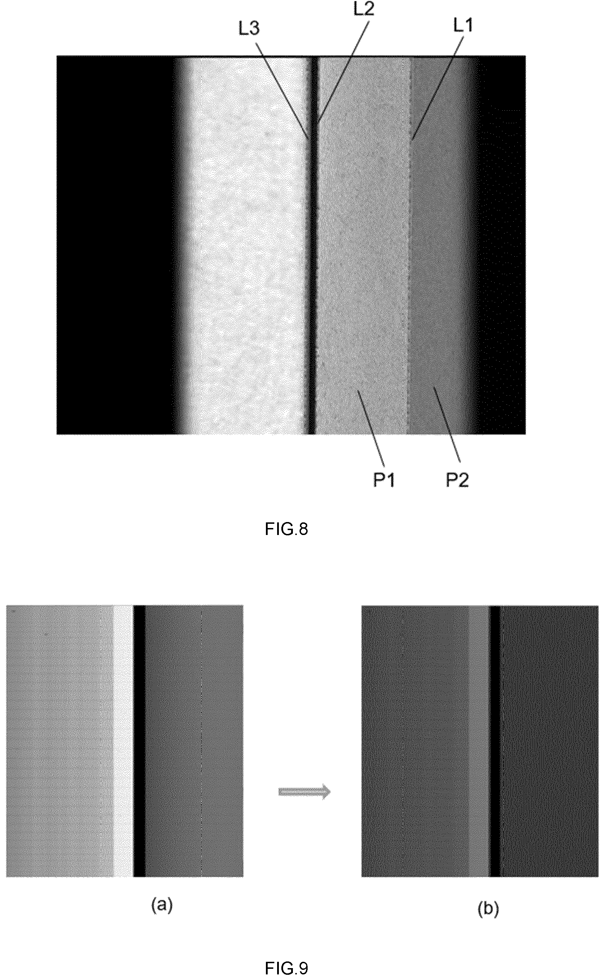

FIG.6 illustrates a 3D schematic of the image edge detection device 500 in one embodiment. FIG.7 illustrates a side view of the image edge detection device 500 in FIG.6. FIG. 8 illustrates a schematic of the edge recognition results from the acquired images.

As shown in FIGS. 6 and 7, the image edge detection device 500 comprises: a line-scan camera 510, an illumination system 520, a rotating stage 530, a positioning unit 540, an alignment unit (not labeled), and an image processing unit (not shown).

The rotating stage 530 is configured to hold the wafer 100 and drive the wafer 100 to rotate around the rotation center. The alignment unit ensures the concentricity between the center of the wafer and the rotation center of the rotating stage. The line-scan camera 510 aligns the edge of the wafer 100 and captures images through line scanning during rotation, stopping when a predetermined height is reached. The image processing unit, electrically connected to the line-scan camera 510, performs edge recognition on specific regions of the acquired images to identify a first line representing the edge of the etched thin layer and a second line representing the edge of the wafer. The image processing unit may use various existing methods for edge recognition. As shown in FIG. 8, P2 is the thin layer (unetched region), and P1 the substrate layer (edge-etched region), it is clearly shown that there is a sudden change in gray scale at the etched edge (the boundary between etched and unetched regions) ,so the first line L1 and the second line L2 can be identified based on the change of gray scale. In the present disclosure, by using the line-scanning method, the imaging data can be converted from the Cartesian coordinate system to the polar coordinate system, thereby simplifying the subsequent image processing algorithm of the image processing unit.

The illumination system 520 provides illumination for the line-scan camera 510. The positioning unit 540 identifies the wafer's notch or wafer flat to position the wafer, enabling the line-scan camera 510 to acquire images at specified positions, such as images at the notch or wafer flat where it rotates 90 degrees, 120 degrees, or 180 degrees, etc. This enables fix-point sampling or random sampling.

When the rotating stage 530 starts rotating, it outputs a synchronization pulse signal to the line-scan camera 510, which then performs scan sampling. The predetermined height may be set as 1/N of the wafer's circumference, where N can be greater than or equal to 1, such as 20, etc. Adjusting N controls the length of the acquired image. To accelerate the detection speed, a larger N can be set.

The image processing unit detects the distance between the first line L1 and the second line L2 and the roughness of the first line L1. The distance represents the etched width, while the roughness of the first line L1 reflects the smoothness of the etched edge. The root mean square error of the first line L1 may quantify its roughness.

In practice, the image processing unit also recognizes a third line L3, where both the second line L2 and the third line L3 represent the edge of the wafer. Due to the curved edge of the wafer, they are recognized as two lines. Typically, the third line L3 corresponds to the outermost edge of the wafer. In other embodiments, adjusting the illumination system or other parameters may allow detection of only the second line L2 or the third line L3. For example, the distance between the third line L3 and the first line L1 may represent the etched width. In this case, only the third line L3 and the first line L1 need to be identified. The lines L1, L2 and L3 can be straight lines or similar straight lines. For example, after magnification, most of the pixels do not form a strict line on the wafer edge, but rather scattered points. However, it overall seems like a straight line.

The following provides further embodiment details.

For 12-inch wafers, after the edge etching process is completed, data on the edge oxide layer and etched edge formation will be collected and analyzed to evaluate whether the stability of the device and the final process effect meet the process requirements. Visual detection of edge etching results is critical in the overall wafer processing, It provides strong references for the correction of the overall device's processing flow, thereby improving the function of the processing device. Once any abnormality is found in the process, processing should be stopped to avoid large amount of wafer loss due to either device abnormalities or other reasons.

A specialized camera and illumination system capture images of the edge of a processed 12-inch wafer, generating a three-level grayscale image distinguishing the etched layer, substrate layer, and the bevel. Image algorithms fit the edges of each layer to assess the edge contour conditions. After the processing procedure, the width of each layer at the wafer edge should fluctuate within a fixed range, and the fluctuation range should not exceed the maximum tolerance specified by the process.

Currently, the image edge detection device 500 can theoretically achieve a minimum particle size of 3.5 μm. However, considering the distortion of the industrial camera used and the noise during the image acquisition process, the actual achievable minimum accuracy is ±10 μm. Generally speaking, the image edge detection device 500 can theoretically detect each wafer in 1 minute or less.

The line-scan camera acquires clear and large-scale images within a very short period of time. After the image acquisition is completed, for the collected images, a dedicated visual processing library is used to perform certain denoising and enhancement on the images. Then, main contours are extracted, and the clear contours are extracted with key points. Using the extracted key points, the least squares method is used to fit the required boundary lines. Finally, the three lines L1, L2 and L3 that are fitted will be obtained.

Part III

However, for wafers of different specifications, whether the substrate surface is polished significantly affects the single-channel grayscale values. For example, some unpolished wafers may have etched region grayscale values between 120-180, while others may range from 70-100; and polished wafers may have etched region grayscale values between 200-255. Thus, the edge detection scheme using grayscale images has cost-increase problems due to different upper and lower limits of grayscale values among different wafers, which requires manual setting for the detection.

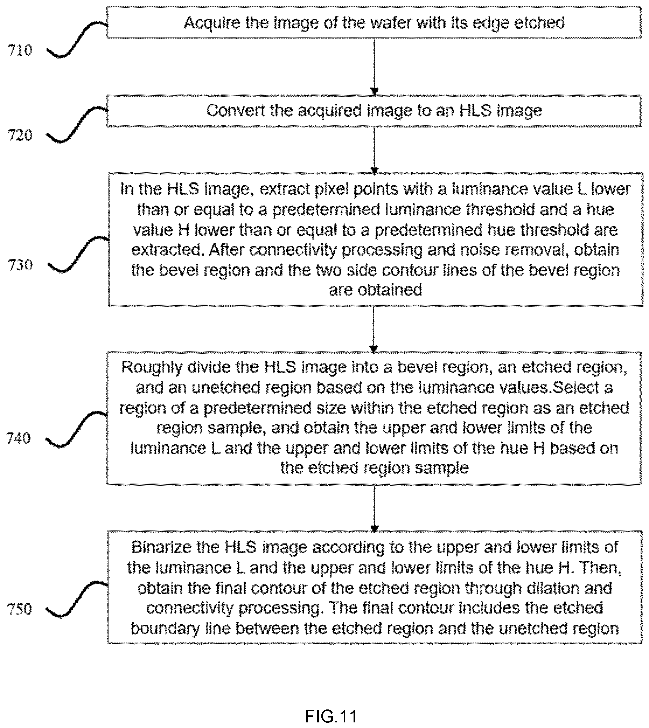

Therefore, in one embodiment, the present disclosure proposes an improved etched edge detection method 700 for a wafer. The etched edge detection method 700 is used to detect wafers with their edges etched, and the etched edge detection method 700 is executed by the image processing unit of the image edge detection device 500. FIG.11 illustrates a flowchart of a edge etched detection method 700 for a wafer according to an embodiment of the present disclosure. As shown in FIG. 11, the method 700 comprises the following steps:

Step 710: Acquire the image of the wafer with its edge etched.

Step 720: Convert the acquired image to an HLS image.

In HLS, H stands for hue, L for luminance and S for saturation.

Whether it is a polished wafer or an unpolished wafer, the etched regions exhibits specific hue values, and the overall color is slightly greenish. FIG. 9 illustrates a comparison between an acquire image of an etched wafer and its HLS image. On the left is the acquired image (i.e., the original image), and on the right is the HLS image, where the etched region is slightly greenish. In this embodiment, the etched region can be confirmed jointly by hue (H) and lightness (L), which has higher accuracy than using grayscale value only.

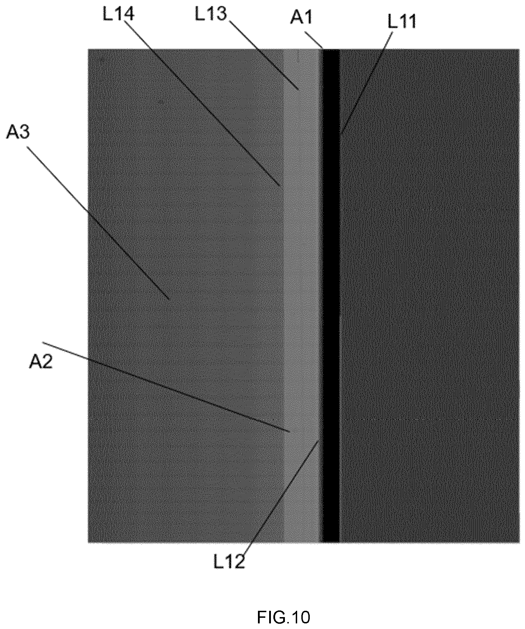

Step 730: In the HLS image, extract pixel points with a luminance value L lower than or equal to a predetermined luminance threshold and a hue value H lower than or equal to a predetermined hue threshold are extracted. After connectivity processing and noise removal, obtain the bevel region and the two side contour lines of the bevel region are obtained. As shown in FIG. 10, L11 is the outer edge contour line of the bevel region, and L12 is the inner edge contour line of the bevel region. For example, if the range of the luminance value and the hue value is 0-255, the predetermined luminance threshold may be 10, and the predetermined hue threshold may be 8 or 0, etc.

Step 740: Roughly divide the HLS image into a bevel region A1, an etched region A2, and an unetched region A3 based on the luminance values. As shown in FIG. 10, select a region of a predetermined size within the etched region as an etched region sample, and obtain the upper and lower limits of the luminance L and the upper and lower limits of the hue H based on the etched region sample. The upper and lower limits include both the upper limit value and the lower limit value. As shown in FIG. 10, the line L13 represents the etched region sample.

Step 750: Binarize the HLS image according to the upper and lower limits of the luminance L and the upper and lower limits of the hue H. Then, obtain the final contour of the etched region through dilation and connectivity processing. The final contour includes the etched boundary line between the etched region and the unetched region. As shown in FIG. 10, L14 is the etched boundary line.

The etched boundary line enables subsequent calculations, such as etched width, etched roughness etc.

This embodiment of the present disclosure determines the upper and lower limits of H (hue) and L (luminance) of the etched region through a fully automatic sampling method, and then obtains the correct contour of the etched region. There is no need to manually adjust the grayscale values to an appropriate range. Meanwhile, using two channels to obtain the contour is more accurate than using a single channel.

Part IV

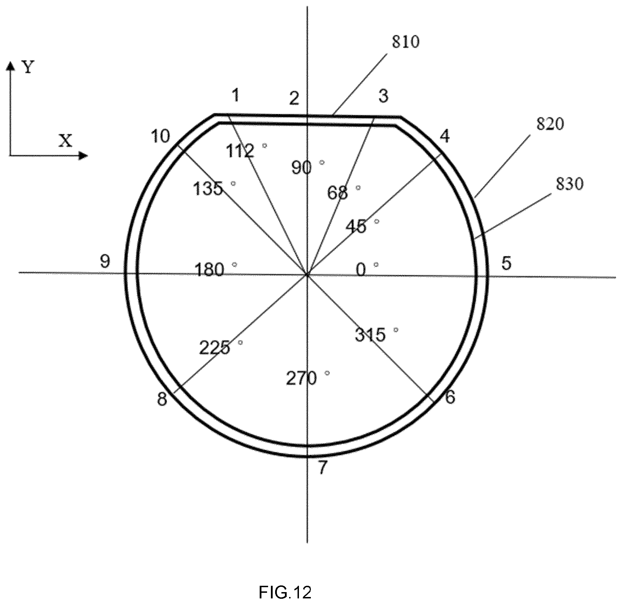

FIG.12 illustrates a top view of a 6-inch wafer with the edge etched. As shown in FIG. 12, the wafer comprises a wafer flat 810, an outer edge contour line 820 at the outermost edge, and an etched boundary line 830 at the inner side. The etched boundary line 830 may be the etched boundary line L14 in FIG. 10, which is obtained through image recognition as described above, and the outer edge contour line 820 may be the line L11 in FIG. 10, which is obtained through image recognition as described above. Of course, FIG. 12 only schematically shows the complete outer edge contour line 820 and etched boundary line 830 of the wafer. In specific implementation, the image edge detection device may only obtain parts of the outer edge contour line 820 and the etched boundary line 830 through image recognition. As can be seen from FIG. 12, if the wafer is precisely centered, the edge of the wafer should be uniformly etched, that is, the etched widths of the 10 measurement points 1-10 in FIG. 12 should be consistent. Therefore, whether the wafer is accurately positioned can be determined by analyzing the etched widths of each measurement point.

As described above, the wafer positioning system further comprises a positioning calibration module 620 and a wafer transfer device 630.

The wafer transfer device 630 comprises a robot and a control unit, wherein the control unit is configured to set or update current position configuration parameters, and the robot is configured to place the fetched wafer on the first supporting area of the lower chamber in the semiconductor processing device 610 at the position corresponding to the set or updated current position configuration parameters. As described above, the semiconductor processing device 610 can etch an edge area of the wafer. As described above, the image edge detection device 500 can acquire and recognize the image of the etched wafer placed based on the current position configuration parameters to obtain etched edge information of the wafer. Specifically, the etched edge can be defined by the outer edge contour line and the etched boundary line, and it certainly can be defined in other ways as well.

The positioning calibration module 620 is used to calculate the position deviation parameters of the current position configuration parameters by using the etched edge information of the wafer obtained through image recognition. The control unit of the wafer transfer device 630 is also used to update the current position configuration parameters based on the position deviation parameters to obtain updated current position configuration parameters, and control the robot to place the fetched wafer on the first supporting area of the lower chamber at a position corresponding to the updated current position configuration parameters.

In one embodiment, after the positioning calibration module 620 calculates the position deviation parameters of the current position configuration parameters, it determines whether the position deviation parameters meet the predetermined position deviation range. If so, it stops updating the current position configuration parameters. If not, it updates the current position configuration parameters based on the position deviation parameter. After obtaining the etched edge of the wafer again with the updated current position configuration parameters, it recalculates the position deviation parameters until the position deviation parameters corresponding to the latest current position parameters meet the predetermined position deviation range.

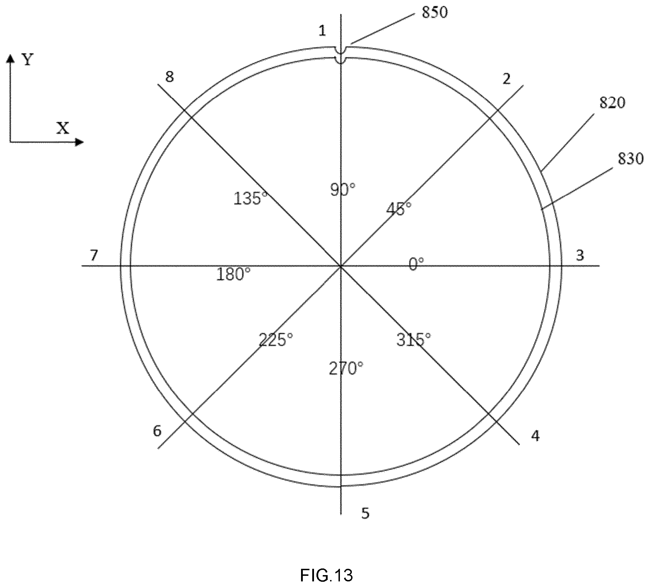

In one embodiment, the positioning calibration module 620 calculates the etched widths at multiple measurement points of the wafer using the etched edge information obtained through image recognition, and calculates the position deviation parameters based on the etched widths at the multiple measurement points. FIG.12 illustrates a top view of a 6-inch wafer with its edge etched. FIG.13 illustrates a top view of an 8-inch or larger wafer with its edge etched. FIG. 12 shows 10 measurement points, namely measurement points 1-10, and FIG. 13 shows 8 measurement points, namely measurement points 1-8. As shown in FIG. 12, the wafer has a wafer flat 810, and as shown in FIG. 13, the wafer has a notch 850.

The position deviation parameter comprises a first direction distance deviation $\Delta x$ and a second direction distance deviation $\Delta y$, while the current position configuration parameter comprises a first direction position coordinate x1 and a second direction position coordinate y1, with the first direction and the second direction perpendicular to each other. The first direction may be the X-axis direction, and the second direction may be the Y-axis direction. Specifically, the first direction distance deviation $\Delta x$ of the position deviation parameter refers to the first direction positioning deviation between the center of the wafer and the center of the first supporting area, and the second direction distance deviation $\Delta y$ of the position deviation parameter refers to the second direction positioning deviation between the center of the wafer and the center of the first supporting area. Based on the first direction position coordinate x1 in the current position configuration parameter and the first direction distance deviation $\Delta x$ in the position deviation parameter, the updated first direction position coordinate in the current position configuration parameter is obtained. Based on the second direction position coordinate y1 in the current position configuration parameter and the second direction distance deviation $\Delta y$ in the position deviation parameter, the updated second direction position coordinate of the current position configuration parameter is obtained.

The multiple measurement points comprise multiple pairs of measurement points. As shown in FIG. 12, measurement points 4 and 8 are a pair, measurement points 5 and 9 are a pair, measurement points 2 and 7 are a pair, and measurement points 6 and 10 are a pair. As shown in FIG. 13, measurement points 1 and 5 are a pair, measurement points 2 and 6 are a pair, measurement points 3 and 7 are a pair, and measurement points 4 and 8 are a pair. The straight line connecting each pair of measurement points passes through the center of the wafer, or it can be said that each pair of measurement points are located at both ends of the diameter of the wafer.

The first direction distance deviation $\Delta x$ of the position deviation parameter corresponds to one or more pairs of measurement points, and a straight line connecting each pair of measurement points corresponding to the first direction distance deviation passes through the center of the wafer. In the embodiment shown in FIG. 12, the first direction distance deviation $\Delta x$ corresponds to three pairs of measurement points, namely 4 and 8, 5 and 9, and 6 and 10. In another embodiment, the first direction distance deviation $\Delta x$ may also correspond to only one pair of measurement points, such as any one of 4 and 8, 5 and 9, and 6 and 10, and it certainly may correspond to more pairs of measurement points as well. Similarly, in FIG. 13, the first direction distance deviation $\Delta x$ also corresponds to three pairs of measurement points, which will not be described in detail here. The first direction distance deviation $\Delta x$ is calculated based on the differences in etched widths between each pair of measurement points in the corresponding one or more pairs of measurement points.

Specifically, as shown in FIG. 12, for example, $\Delta x = |w5-w9|/2$, where w5 is the etched width of measurement point 5, and w9 is the etched width of measurement point 9. For another example,

$$\Delta x = |w4-w8|/2\sqrt{2}$$, where w4 is the etched width of measurement point 4, and w8 is the etched width of measurement point 8. For another example,

$$\Delta x = |w6-w10|/2\sqrt{2}$$, where w6 is the etched width of measurement point 6, and w10 is the etched width of measurement point 10. Of course, $\Delta x$ can also be calculated by combining w5 and w9, w4 and w8, and w6 and w10. In this example, $\Delta x$ is a positive value, and the updated first direction position coordinate in current configuration parameters becomes $x1_d = x1 \pm \Delta x$. This means when the first direction distance deviation $\Delta x$ shifts toward one direction of the X-axis, it is $x1_d = x1 + \Delta x$; while when the first direction distance deviation $\Delta x$ shifts toward another direction of the X-axis, it is $x1_d = x1 - \Delta x$. The second direction distance deviation $\Delta y$ of the position deviation parameters corresponds to one or more pairs of measurement points, and a straight line connecting each pair of measurement points corresponding to the second direction distance deviation passes through the center of the wafer. In the embodiment shown in FIG. 12, the second direction distance deviation $\Delta y$ corresponds to three pairs of measurement points, namely 4 and 8, 5 and 9, and 6 and 10. In another embodiment, the second direction distance deviation $\Delta y$ may also correspond to only one pair of measurement points, such as any one of 4 and 8, 5 and 9, and 6 and 10, and it may certainly correspond to more pairs of measurement points as well. Similarly, in FIG. 13, the second direction distance deviation $\Delta y$ also corresponds to three pairs of measurement points, which will not be described in detail here. The second direction distance deviation $\Delta y$ is calculated based on the differences in etched widths between each pair of measurement points in the corresponding one or more pairs of measurement points.

Specifically, as shown in FIG. 12, for example, $\Delta y = |w2-w7|/2$, where w2 is the etched width of measurement point 2, and w7 is the etched width of measurement point 7. For another example, $\Delta y = |w4\text{-}w8|/2\sqrt{2}$, where w4 is the etched width of measurement point 4, and w8 is the etched width of measurement point 8. For another example, $\Delta y = |w6\text{-}w10|/2\sqrt{2}$, where w6 is the etched width of measurement point 6, and w10 is the etched width of measurement point 10. Of course, $\Delta y$ can also be calculated by combining w2 and w7, w4 and w8, and w6 and w10. In this example, $\Delta y$ is a positive value, and the updated second direction position coordinate in current configuration parameters becomes $y1_d = y1 \pm \Delta y$. This means when the second direction distance deviation $\Delta y$ shifts toward one direction of the Y-axis, it is $y1_d = y1 + \Delta y$; while when the first direction distance deviation $\Delta y$ shifts toward another direction of the Y-axis, it is

$$y1_d = y1 - \Delta y.$$

Of course, in another embodiment, it can also be defined that both $\Delta y$ and $\Delta x$ are positive or negative values. For example, shifting toward one direction is positive values, and shifting toward another direction is negative values. In this case,

$$y1_d = y1_d = y1 + \Delta y, x1_d = x1 + \Delta x.$$

It can be seen that the one or more pairs of measurement points corresponding to the first direction distance deviation $\Delta x$ overlap with the one or more pairs of measurement points corresponding to the second direction distance deviation $\Delta y$. Since measurement point 4 is at 45 degrees, measurement point 8 at 225 degrees, measurement point 6 at 315 degrees, and measurement point 10 at 135 degrees, the differences in etched width between the measurement point pairs 4 and 8 and/or the differences in etched width between the measurement point pairs 6 and 10 can be used to calculate both $\Delta x$ and $\Delta y$.

In one embodiment, the position deviation parameter comprises a positioning angle deviation $\Delta\theta$, and the current position configuration parameter comprises a positioning angle $\theta$. An updated positioning angle in the current configuration parameter is obtained based on the positioning angle $\theta$ in the current position configuration parameter and the positioning angle deviation $\Delta\theta$ in the position deviation parameters. For example, the positioning angle of the updated current configuration parameters $=\theta+\Delta\theta$. The positioning angle deviation of the position deviation parameter refers to a positioning angle deviation between the wafer and the first supporting area. For example, as shown in FIG. 12, for a 6-inch wafer, which has a positioning flat 810, if the positioning angle of the wafer does not match the positioning angle of the first supporting area, the etched width of the positioning flat 810 will also be inconsistent. The positioning angle deviation of the position deviation parameter corresponds to multiple measurement points. As shown in FIG. 12, the positioning angle deviation corresponds to three measurement points, which are measurement points 1, 2, and 3. In other embodiments, the positioning angle deviation can also be calculated by using only two of the measurement points such as 1 and 3. A fitted straight-line slope of the multiple measurement points is calculated based on the differences in etched widths and distances between the corresponding multiple measurement points. The positioning angle deviation $\Delta\theta$ is derived based on the fitted straight-line slope. For example, the distance between measurement points 1 and 3 is D1, and the fitted straight-line slope $K=(w1\text{-}w3)/D1=\tan\alpha$, where w1 is the etched width of measurement point 1 and w3 is the etching width of measurement point 3.

For wafers of 8 inches and above, the wafer does not have a wafer flat but is provided with a notch 850 (see FIG. 13). When the wafer has a notch 850, the semiconductor processing device 200 will set a guide pin at a corresponding position of the upper chamber 220 or the lower chamber 210. The guide pin cooperates with the notch 850 to realize the angle positioning of the wafer. If the guide pin still cannot precisely position the wafer at the correct angle, the etched width of the measurement points can also be used to determine the positioning angle deviation. Specifically, the positioning angle deviation of the position deviation parameter corresponds to one or more pairs of measurement points, and each pair of measurement points corresponding to the angle deviation are located on both sides of the notch 850 of the wafer, The positioning angle deviation is calculated based on the differences in etched widths between each pair of measurement points in the corresponding one or more pairs of measurement points. The larger the positioning angle deviation is, the larger the differences in etched width between the measurement points on both sides of the notch 850 will be.

In this disclosure, the calibration of the robot comprises: configuring current position configuration parameters; placing the wafer at a position corresponding to the current position configuration parameters for edge etching; recognizing the image of the etched wafer to obtain the etched edge and etched width of the wafer; calculating the position deviation parameter of the current position configuration parameter based on the etched edge of the wafer; determining whether the position deviation parameters meet the predetermined position deviation range; if the position deviation parameters do not meet the predetermined position deviation range, update or calibrate the current position configuration parameters based on the position deviation parameter. In the present disclosure, multiple calibrations may be required to make the position deviation parameters meet the predetermined position deviation range, thereby stopping the wafer positioning. Since each calibration process is the same, it will not be further repeated here.

In addition, even if the current position configuration parameters have been calibrated and the wafer can be precisely positioned, after a period of time, for example, due to temperature changes, variations in wafer size caused by different wafer batches, or changes in other factors, the quality of the etched edge of the wafer may no longer meet the requirements. At this point, the current position configuration parameters can be recalibrated, that is, the wafer can be repositioned until the quality of the etched edge of the wafer meets the requirements. The key point is that the position deviation parameters meet the predetermined position deviation range.

In this way, in the present disclosure, the positioning of the wafer can be realized by continuously calibrating the current position configuration parameters of the robot. This solution can cooperate with the protrusion part of the semiconductor processing device 200 mentioned above to position the wafer 100 together, and it is also certain that it can realize the wafer positioning alone.

Regarding how the robot specifically places the fetched wafer at a position corresponding to the current position configuration parameters according to the current position configuration parameters, this can be achieved by referencing existing technologies. For example, by teaching, an operator can first guide the robot to fetch a wafer from a wafer cassette and transfer the wafer to a specified position on the first support area of the lower chamber in the semiconductor processing device 200 . At this time, the control unit can obtain the current position configuration parameters corresponding to the specified position. For another example, the current position configuration parameters can also be directly set in the control unit.

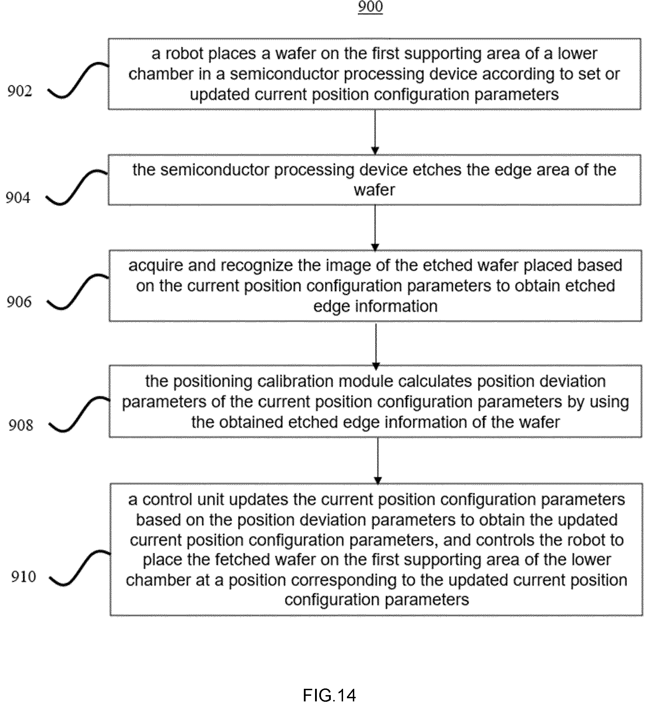

In one aspect, the present disclosure provides a wafer positioning method. FIG.14 illustrates a flowchart of the wafer positioning method 900 in one embodiment. As shown in FIG.14, the wafer positioning method 900 comprises the following steps:

> Step 902: a robot places a wafer on the first supporting area of a lower chamber in a semiconductor processing device according to set or updated current position configuration parameters.

> Step 904: the semiconductor processing device etches the edge area of the wafer. Refer to first part of the content for specific etching process.

> Step 906: acquire and recognize the image of the etched wafer placed based on the current position configuration parameters to obtain etched edge information (e.g. the etched width and etched boundary line) of the wafer. Refer to the second and third part of the content for specific image recognition.

> Step 908: the positioning calibration module calculates position deviation parameters of the current position configuration parameters by using the obtained etched edge information of the wafer.

> Step 910: a control unit updates the current position configuration parameters based on the position deviation parameters to obtain the updated current position configuration parameters, and controls the robot to place the fetched wafer on the first supporting area of the lower chamber at a position corresponding to the updated current position configuration parameters.

In one embodiment, wherein after the positioning calibration module calculates the position deviation parameters of the current position configuration parameters, the method further comprises: determining whether the position deviation parameters meet the predetermined position deviation range. If so, it stops updating the current position configuration parameters. If not, it updates the current position configuration parameters based on the position deviation parameter. After obtaining the etched edge of the wafer again with the updated current position configuration parameters, it recalculates until the position deviation parameters corresponding to the latest current position parameters meet the predetermined position deviation range.

The other contents of the wafer positioning method 900 can be referred to the corresponding parts in the wafer positioning system described above. Therefore, they will not be further repeated here.

The above description is intended to be illustrative, and not restrictive. Although the present disclosure has been described with references to specific illustrative examples, it will be recognized that the present disclosure is not limited to the examples described. The scope of the disclosure should be determined with reference to the following claims, along with the full scope of equivalents to which the claims are entitled.

As used herein, "one example (embodiment)" or "example (embodiment)" means that a specific feature, structure, or characteristic related to the embodiment is comprised in at least one implementation of the present invention. The appearances of "in one embodiment" in different places in this specification are not necessarily all referring to the same embodiment, nor do they have to be separate or alternative embodiments that are mutually exclusive with other embodiments. The terms "plural" and "several" in the present invention mean two or more. The term "and/or" in the present invention means "and" or "or". In addition, the terms "first", "second", "third", "fourth", etc. used herein are intended as labels to distinguish different elements, and their numerical designations may not necessarily imply a sequential meaning. Therefore, the terms used herein are only for the purpose of describing specific implementations and are not intended to be limiting.

It should also be noted that in some alternative embodiments, the functions/acts noted may occur out of the order noted in the figures. For example, two figures shown in succession may in fact be executed substantially concurrently or may sometimes be executed in the reverse order, depending upon the functionality/acts involved.

Although the method operations were described in a specific order, it should be understood that other operations may be performed in between described operations. Described operations may be adjusted so that they occur at slightly different times or the described operations may be distributed in a system. The system allows the occurrence of the processing operations at various intervals associated with the processing.

Many modifications and other embodiments of the disclosure set forth herein will come to mind to one skilled in the art to which the disclosure pertains having the benefit of the teachings presented in the foregoing description and the associated figures. Therefore, it is to be understood that the disclosure is not to be limited to the specific embodiments disclosed and that modifications and other embodiments are intended to be included within the scope of the appended claims. Moreover, although the foregoing description and the associated figures describe example embodiments in the context of certain example combinations of elements and/or functions, it should be appreciated that different combinations of elements and/or functions may be provided by alternative embodiments without departing from the scope of the appended claims. In this regard, for example, different combinations of elements and/or functions than those explicitly described above are also contemplated as may be set forth in some of the appended claims. Although specific terms are employed herein, they are used in a generic and descriptive sense only and not for purposes of limitation.

**Claims**

1. A wafer positioning system, comprising:

   a semiconductor processing device comprising a lower chamber with a first supporting area and an upper chamber with a second supporting area, wherein when the upper chamber engages with the lower chamber with a wafer placed between the first supporting area and the second supporting area, a first channel is formed at an edge area of the first supporting area and/or the second supporting area, and the first channel is configured to provide a first space for flow of one or more chemical fluids for etching an edge area of the wafer;
   a wafer transfer device comprising a robot and a control unit, wherein the control unit is configured to set or update current position configuration parameters, and the robot is configured to place the fetched wafer on the first supporting area of the lower chamber at a position corresponding to the set or updated current position configuration parameters;
an image edge detection device is configured to acquire and recognize images of the etched wafer placed based on the current position configuration parameters to obtain etched edge information of the wafer;
a positioning calibration module is configured to calculate position deviation parameters of the current position configuration parameters using the etched edge information obtained through image recognition;
wherein the control unit is further configured to update the current position configuration parameters based on the position deviation parameters to obtain the updated current position configuration parameters, and control the robot to place the fetched wafer on the first supporting area of the lower chamber at a position corresponding to the updated current position configuration parameters.

2. The wafer positioning system of claim 1, wherein after the positioning calibration module calculates the position deviation parameters of the current position configuration parameters, it determines whether the position deviation parameters meet a predetermined position deviation range, if so, it stops updating the current position configuration parameters, if not, it updates the current position configuration parameters based on the position deviation parameters, it recalculates the position deviation parameters after obtaining the etched edge of the wafer again with the updated current position configuration parameters until the position deviation parameters corresponding to the latest current position parameters meet the predetermined position deviation range.

3. The wafer positioning system of claim 1, wherein the positioning calibration module calculates etched widths at multiple measurement points of the wafer using the etched edge information obtained through image recognition, and calculates the position deviation parameters based on the etched widths at multiple measurement points.

4. The wafer positioning system of claim 3, wherein the position deviation parameters comprise a first direction distance deviation and a second direction distance deviation, while the current position configuration parameters comprise a first direction position coordinate and a second direction position coordinate, with the first direction and the second direction perpendicular to each other;
the first direction position coordinate in the updated current position configuration parameters is obtained based on the first direction position coordinate in the current position configuration parameters and the first direction distance deviation in the position deviation parameters, and the second direction position coordinate in the updated current position configuration parameters is obtained based on the second direction position coordinate in the current position configuration parameters and the second direction distance deviation in the position deviation parameters.

5. The wafer positioning system of claim 4, wherein the first direction distance deviation of the position deviation parameter refers to a first direction positioning deviation between a center of the wafer and a center of the first supporting area; and
the second direction distance deviation of the position deviation parameter refers to a second direction positioning deviation between the center of the wafer and the center of the first supporting area.

6. The wafer positioning system of claim 4, wherein the multiple measurement points comprise multiple pairs of measurement points,

> the first direction distance deviation of the position deviation parameters corresponds to one or more pairs of measurement points, and a straight line connecting each pair of measurement points corresponding to the first direction distance deviation passes through the center of the wafer, the first direction distance deviation is calculated based on differences in the etched widths between each pair of measurement points in the corresponding one or more pairs of measurement points,
> alternatively, the second direction distance deviation of the position deviation parameters corresponds to one or more pairs of measurement points, and a straight line connecting each pair of measurement points corresponding to the second direction distance deviation passes through the center of the wafer, the second direction distance deviation is calculated based on differences in the etched widths between each pair of measurement points in the corresponding one or more pairs of measurement points.

7. The wafer positioning system of claim 6, wherein the one or more pairs of measurement points corresponding to the first direction distance deviation overlap with the one or more pairs of measurement points corresponding to the second direction distance deviation.

8. The wafer positioning system of claim 4, wherein the position deviation parameters further comprise a positioning angle deviation, and the current position configuration parameter further comprises a positioning angle, an updated positioning angle in the current configuration parameter is obtained based on the positioning angle in the current position configuration parameter and the positioning angle deviation in the position deviation parameter, the positioning angle deviation of the position deviation parameter refers to a positioning angle deviation between the wafer and the first supporting area.

9. The wafer positioning system of claim 8, wherein the positioning angle deviation of the position deviation parameters corresponds to multiple measurement points, and a fitted straight-line slope of the multiple measurement points is calculated based on the differences in etched widths and distances between the corresponding multiple measurement points, the positioning angle deviation is derived based on the fitted straight-line slope; or
the positioning angle deviation of the position deviation parameters corresponds to one or more pairs of measurement points, and each pair of measurement points corresponding to the angle deviation are located on both sides of a notch of the wafer, the positioning angle deviation is calculated based on the differences in etched widths between each pair of measurement points in the corresponding one or more pairs of measurement points.

10. The wafer positioning system of claim 1, wherein the first channel is formed at an edge area of the second supporting area, and one or more chemical fluids flow between the first space and an exterior of the semiconductor processing device through a first through hole located in the upper chamber; and/or the first channel is formed at an edge area of the first supporting area, and the lower chamber comprises a first through hole, through which one or more chemical fluids flow between the first space and the exterior of the semiconductor processing device.

11. A wafer positioning method, comprising:

> placing, by a robot, a wafer on a first supporting area of a lower chamber of a semiconductor processing device according to set or updated current position configuration parameters;
> etching an edge area of the wafer using the semiconductor processing device;
> performing image acquisition and recognition to the etched wafer placed based on the current position configuration parameters to obtain etched edge information of the wafer;
> calculating position deviation parameters of the current position configuration parameters using a positioning calibration module with the obtained etched edge information of the wafer; and updating, by a control unit, the current position configuration parameters based on the position deviation parameters to obtain the updated current position configuration parameters, and controlling the robot to place the obtained wafer on the first supporting area of the lower chamber at a position corresponding to the updated current position configuration parameters.

12. The wafer positioning method of claim 11, wherein after the calculating position deviation parameters of the current position configuration parameters using a positioning calibration module, the method further comprises:

determining whether the position deviation parameters meet a predetermined position deviation range;
stopping updating the current position configuration parameters If so; and
updating the current position configuration parameters based on the position deviation parameter If not, and recalculating the position deviation parameters after obtaining the etched edge of the wafer again with the updated current position configuration parameters until the position deviation parameters corresponding to the latest current position parameters meet the predetermined position deviation range.

13. The wafer positioning method of claim 11, wherein the positioning calibration module calculates etched widths at multiple measurement points of the wafer using the etched edge information obtained through image recognition, and calculates the position deviation parameters based on the etched widths at the multiple measurement points.

14. The wafer positioning method of claim 13, wherein the position deviation parameter comprises a first direction distance deviation and a second direction distance deviation, while the current position configuration parameter comprises a first direction position coordinate and a second direction position coordinate, with the first direction and the second direction perpendicular to each other;
the updated first direction position coordinate in the current position configuration parameter is obtained base on the first direction position coordinate in the current position configuration parameter and the first direction distance deviation in the position deviation parameter, the updated second direction position coordinate of the current position configuration parameter is obtained base on the second direction position coordinate in the current position configuration parameter and the second direction distance deviation in the position deviation parameter.

15. The wafer positioning method of claim 14, wherein the multiple measurement points comprise multiple pairs of measurement points,

the first direction distance deviation of the position deviation parameter corresponds to one or more pairs of measurement points, a straight line connecting each pair of measurement points corresponding to the first direction distance deviation passes through the center of the wafer, and the first direction distance deviation is calculated based on the differences in the etched widths between each pair of measurement points in the corresponding one or more pairs of measurement points,
alternatively, the second direction distance deviation of the position deviation parameters corresponds to one or more pairs of measurement points, and a straight line connecting each pair of measurement points corresponding to the second direction distance deviation passes through the center of the wafer, and the second direction distance deviation is calculated based on the differences in the etched widths between each pair of measurement points in the corresponding one or more pairs of measurement points.

16. The wafer positioning method of claim 14, wherein the position deviation parameter comprises a positioning angle deviation, the current position configuration parameter comprises a positioning angle, an updated positioning angle in the current configuration parameter is obtained based on the positioning angle in the current position configuration parameter and the positioning angle deviation in the position deviation parameter, and the positioning angle deviation of the position deviation parameter refers to a positioning angle deviation between the wafer and the first supporting area,

the positioning angle deviation of the position deviation parameters corresponds to multiple measurement points, and a fitted straight-line slope of the multiple measurement points is calculated based on the differences in the etched widths and distances between the corresponding multiple measurement points, the positioning angle deviation is derived based on the fitted straight-line slope; or
the positioning angle deviation of the position deviation parameters corresponds to one or more pairs of measurement points, and each pair of measurement points corresponding to the angle deviation are located on both sides of a notch of the wafer, the positioning angle deviation is calculated based on the differences in the etched widths between each pair of measurement points in the corresponding one or more pairs of measurement points.

17. The wafer positioning method of claim 11, wherein a semiconductor processing device comprises a lower chamber with a first supporting area and an upper chamber with a second supporting area, wherein when the upper chamber engages with the lower chamber with the wafer placed between the first supporting area and the second supporting area, a first channel is formed at an edge area of the first supporting area and/or the second supporting area, wherein the first channel is configured to provide a first space for flow of one or more chemical fluids for etching the edge area of the wafer.

FIG. 1a

102

Etched
width

Etched
width

A - A

101

FIG.1b

FIG. 2a

FIG. 2b

FIG. 2c

FIG. 2d

FIG. 2e

FIG. 2f

300

FIG.3

<u>400</u>

402 — placing a wafer on a first supporting area of a lower chamber of the device

404 — the device engages its upper chamber with its lower chamber to place the wafer between the first supporting area and a second supporting area of the upper chamber

406 — a first channel is formed at a peripheral area of the first supporting area or the second supporting area, where in the first channel provides a first space

408 — the device uses a protrusion part to press against an edge of the wafer and to align a center axis of the wafer with a center axis of the second supporting area

410 — the device injects one or more chemical fluids into the first space for etching an edge area of the wafer

FIG.4

630
wafer
transfer
device

610
semiconductor
processing
device

500
image
edge
detection
device

620
positioning
calibration
module

FIG. 5

500

510

520

100

540

530

FIG.6

FIG.7

FIG.8

(a)          (b)

FIG.9

FIG.10

710 — Acquire the image of the wafer with its edge etched

720 — Convert the acquired image to an HLS image

730 — In the HLS image, extract pixel points with a luminance value L lower than or equal to a predetermined luminance threshold and a hue value H lower than or equal to a predetermined hue threshold are extracted. After connectivity processing and noise removal, obtain the bevel region and the two side contour lines of the bevel region are obtained

740 — Roughly divide the HLS image into a bevel region, an etched region, and an unetched region based on the luminance values.Select a region of a predetermined size within the etched region as an etched region sample, and obtain the upper and lower limits of the luminance L and the upper and lower limits of the hue H based on the etched region sample

750 — Binarize the HLS image according to the upper and lower limits of the luminance L and the upper and lower limits of the hue H. Then, obtain the final contour of the etched region through dilation and connectivity processing. The final contour includes the etched boundary line between the etched region and the unetched region

FIG.11

FIG.12

FIG.13

<u>900</u>

902 a robot places a wafer on the first supporting area of a lower chamber in a semiconductor processing device according to set or updated current position configuration parameters

904 the semiconductor processing device etches the edge area of the wafer

906 acquire and recognize the image of the etched wafer placed based on the current position configuration parameters to obtain etched edge information

908 the positioning calibration module calculates position deviation parameters of the current position configuration parameters by using the obtained etched edge information of the wafer

910 a control unit updates the current position configuration parameters based on the position deviation parameters to obtain the updated current position configuration parameters, and controls the robot to place the fetched wafer on the first supporting area of the lower chamber at a position corresponding to the updated current position configuration parameters

FIG.14

## INTERNATIONAL SEARCH REPORT

| | International application No. |
|---|---|
| | **PCT/CN2023/130222** |

**A. CLASSIFICATION OF SUBJECT MATTER**

H01L21/68(2006.01)i

According to International Patent Classification (IPC) or to both national classification and IPC

**B. FIELDS SEARCHED**

Minimum documentation searched (classification system followed by classification symbols)

IPC: H01L21/-

Documentation searched other than minimum documentation to the extent that such documents are included in the fields searched

Electronic data base consulted during the international search (name of data base and, where practicable, search terms used)

CNABS; CNTXT; ENTXT; VEN; USTXT; EPTXT; JPTXT; WOTXT; CNKI: 晶圆, 晶片, 定位, 对准, 校准, 矫正, 边缘, 宽度, 检测, 测量, wafer, position, align, correction, edge, width, detect, measure

**C. DOCUMENTS CONSIDERED TO BE RELEVANT**

| Category* | Citation of document, with indication, where appropriate, of the relevant passages | Relevant to claim No. |
|---|---|---|
| X | CN 112951733 A (CHANGXIN MEMORY TECHNOLOGIES, INC.) 11 June 2021 (2021-06-11) description, paragraphs 44-64, and figures 1-14 | 11-12 |
| Y | CN 112951733 A (CHANGXIN MEMORY TECHNOLOGIES, INC.) 11 June 2021 (2021-06-11) description, paragraphs 44-64, and figures 1-14 | 1-10, 13-17 |
| Y | CN 114188265 A (HUAYING RESEARCH CO., LTD.) 15 March 2022 (2022-03-15) description, paragraphs 55-97, and figures 2a-6 | 1-10, 13-17 |
| X | CN 113785387 A (LAM RESEARCH CORP.) 10 December 2021 (2021-12-10) description, paragraphs 24-53, and figures 1-4D | 11-12 |
| Y | CN 113785387 A (LAM RESEARCH CORP.) 10 December 2021 (2021-12-10) description, paragraphs 24-53, and figures 1-4D | 1-10, 13-17 |
| Y | CN 217691071 U (HUAYING RESEARCH CO., LTD.) 28 October 2022 (2022-10-28) description, paragraphs 41-92, and figures 2a-6 | 1-10, 13-17 |

☑ Further documents are listed in the continuation of Box C.   ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **20 February 2024** | **27 February 2024** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2023/130222** |

| C. | DOCUMENTS CONSIDERED TO BE RELEVANT | |
| --- | --- | --- |
| Category* | Citation of document, with indication, where appropriate, of the relevant passages | Relevant to claim No. |
| A | CN 101501831 A (SHIBAURA MECHATRONICS CORP.) 05 August 2009 (2009-08-05)<br>entire document | 1-17 |
| A | KR 20190041126 A (WONIK IPS CO., LTD.) 22 April 2019 (2019-04-22)<br>entire document | 1-17 |

Form PCT/ISA/210 (second sheet) (July 2022)

**INTERNATIONAL SEARCH REPORT**
Information on patent family members

International application No.

**PCT/CN2023/130222**

| Patent document cited in search report | | | Publication date (day/month/year) | Patent family member(s) | | | Publication date (day/month/year) |
|---|---|---|---|---|---|---|---|
| CN | 112951733 | A | 11 June 2021 | CN | 211017008 | U | 14 July 2020 |
| CN | 114188265 | A | 15 March 2022 | JP | 2023506425 | A | 16 February 2023 |
| | | | | WO | 2022057790 | A1 | 24 March 2022 |
| | | | | EP | 4120330 | A1 | 18 January 2023 |
| | | | | US | 2023135250 | A1 | 04 May 2023 |
| | | | | CN | 114188266 | A | 15 March 2022 |
| | | | | CN | 216389313 | U | 26 April 2022 |
| | | | | CN | 216389314 | U | 26 April 2022 |
| CN | 113785387 | A | 10 December 2021 | WO | 2020180607 | A1 | 10 September 2020 |
| | | | | JP | 2022522467 | A | 19 April 2022 |
| | | | | TW | 202101654 | A | 01 January 2021 |
| | | | | US | 2022134568 | A1 | 05 May 2022 |
| | | | | KR | 20210125107 | A | 15 October 2021 |
| CN | 217691071 | U | 28 October 2022 | CN | 116844993 | A | 03 October 2023 |
| | | | | WO | 2023179194 | A1 | 28 September 2023 |
| CN | 101501831 | A | 05 August 2009 | KR | 20090036131 | A | 13 April 2009 |
| | | | | KR | 101016864 | B1 | 22 February 2011 |
| | | | | TW | 200818370 | A | 16 April 2008 |
| | | | | TWI | 426226 | B | 11 February 2014 |
| | | | | US | 2010177953 | A1 | 15 July 2010 |
| | | | | US | 8107064 | B2 | 31 January 2012 |
| | | | | JPWO | 2008018537 | A1 | 07 January 2010 |
| | | | | JP | 5099848 | B2 | 19 December 2012 |
| | | | | WO | 2008018537 | A1 | 14 February 2008 |
| | | | | CN | 101501831 | B | 04 April 2012 |
| KR | 20190041126 | A | 22 April 2019 | KR | 102283220 | B1 | 30 July 2021 |

Form PCT/ISA/210 (patent family annex) (July 2022)